# EUROPÄISCHE PATENTSCHRIFT

(11) **EP 3 257 339 B1**
(45) Veröffentlichungstag und Bekanntmachung des Hinweises auf die Patenterteilung: **25.09.2019**
(21) Anmeldenummer: 16702704.4
(22) Anmeldetag: 01.02.2016
(51) Int. Cl.: H05K 5/00, H05K 5/06

(54) **MECHATRONISCHE KOMPONENTE UND VERFAHREN ZU DEREN HERSTELLUNG**
MECHATRONIC COMPONENT AND METHOD FOR THE PRODUCTION THEREOF
COMPOSANT MÉCATRONIQUE ET SON PROCÉDÉ DE FABRICATION

(30) Priorität: 10.02.2015 DE 102015202311; 20.05.2015 DE 102015209191
(43) Veröffentlichungstag der Anmeldung: 20.12.2017
(73) Patentinhaber: Conti Temic Microelectronic GmbH, 90411 Nürnberg (DE)
(72) Erfinder: ALBERT, Andreas, 91315 Höchstadt/Aisch (DE); PLACH, Andreas, 91301 Forchheim (DE); SCHMIDT, Thomas, 93133 Burglengenfeld (DE); SCHUCH, Bernhard, 91616 Neusitz (DE); STEINAU, Martin, 90489 Nürnberg (DE); STRECKER, Mathias, 74564 Crailshelm (DE); WIECZOREK, Matthias, 91233 Neunkirchen am Sand (DE)
(74) Vertreter: Bonn, Roman Klemens
(86) Internationale Anmeldenummer: PCT/EP2016/052096
(87) Internationale Veröffentlichungsnummer: WO 2016/128245

(56) Entgegenhaltungen:
- WO-A1-2006/066983
- DE-A1-102011 006 632
- DE-A1-102014 205 386
- US-A- 5 909 915

## Beschreibung

Die Erfindung betrifft eine mechatronische Baugruppe gemäß dem Oberbegriff des Anspruchs 1. Die Erfindung betrifft weiterhin ein Verfahren zur Herstellung einer mechatronischen Baugruppe gemäß dem Oberbegriff des Anspruchs 9.

Mechatronische Baugruppen in Form integrierter Schaltungen umfassen üblicherweise elektronische Komponenten, die auf einer Trägerleiterplatte zu einer elektrischen Schaltungsanordnung zusammengeführt sind, sowie mechanische Komponenten auf denen z.B. Sensoren verbaut sind. Alternativ können die elektronischen Komponenten auch mit einem Stanzgitter verbunden sein, welches sich in einer Umhausung befindet. Nach dem Stand der Technik sind diese mechatronischen Baugruppen auf einer Grundplatte - z.B. aus Aluminium mittels Verbindungselementen montiert, die einer mechanischen Stabilisierung und Entwärmung der mechatronischen Baugruppe dient. Derartige mechatronische Baugruppen werden beispielsweise als Steuergeräte in Kraftfahrzeugen, z. B. als Getriebesteuergerät, eingesetzt.

Steuergeräte werden üblicherweise mittels Abdeckungen vor äußeren Einflüssen, z. B. Getriebeöl, geschützt. Dabei werden Dichtungen, Verklebungen oder stoffschlüssige Verbindungen zwischen der Trägerleiterplatte und der Abdeckung eingesetzt.

Beispielsweise werden auf der Trägerleiterplatte angeordnete, modulartige elektronische Baugruppen und elektronische Komponenten jeweils von einem separaten Gehäuse umschlossen.

Eine elektrische Kontaktierung der elektronischen Baugruppen und elektronischen Komponenten erfolgt z. B. über ein Stanzgitter, welches elektrische Anschlussstifte aufweist, die entlang einer Formtrennung der Kavität herausgeführt sind. Alternativ erfolgt die elektrische Kontaktierung mittels einer rückseitigen Kontaktierung eines aus dem Kunststoffgehäuse herausragenden Leiterplattenelements.

Die Dimensionen mit Kunststoff umschlossener elektronischer Komponenten liegen im Bereich von einigen Millimetern für Mikrochips bis hin zu mehreren Zentimetern für komplette Elektroniken auf diversen Schaltungsträgern. Bei modulartiger Ausführung der mechatronischen Baugruppe müssen nach außen geführte elektrische Anschlüsse gegen metallische Späne und/oder aggressive Medien geschützt werden. Dies ist mittels Beschichtungen, zusätzlicher Kunststoffteile oder Deckel möglich. Hierdurch entsteht allerdings ein erhöhter Fertigungsaufwand.

Aus der WO 2006/066983 A1 ist ein Steuermodul für ein Getriebe eines Kraftfahrzeuges bekannt. Das Steuermodul weist ein Trägerteil und ein an dem Trägerteil angeordnetes Steuergerät auf. Das Steuergerät umfasst ein erstes Gehäuseteil und ein zweites Gehäuseteil und ein zwischen dem ersten Gehäusesteil und dem zweiten Gehäuseteil angeordnetes elektronisches Schaltungsmodul. Über eine flexible Leiterfolie kann das zwischen den beiden Gehäuseteilen angeordnete Schaltungsteil mit außerhalb des Gehäuseteils angeordneten elektronischen Bauteilen verbunden werden.

Die US 5 909 915 A beschreibt ein mit Harz umgossenes elektronisches Schaltkreisgerät.

Der Erfindung liegt die Aufgabe zu Grunde, eine verbesserte mechatronische Baugruppe sowie ein Verfahren zur Herstellung einer mechatronischen Baugruppe anzugeben.

Hinsichtlich der mechatronischen Baugruppe wird die Aufgabe erfindungsgemäß mit den in Anspruch 1 angegebenen Merkmalen und hinsichtlich des Verfahrens mit den in Anspruch 9 angegebenen Merkmalen gelöst.

Vorteilhafte Ausgestaltungen der Erfindung sind Gegenstand der Unteransprüche.

Eine mechatronische Baugruppe umfasst eine Trägerleiterplatte mit wenigstens einer bestückten Flachseite, auf der folgende Komponenten angeordnet sind:
- eine Mehrzahl elektronischer Bauteile, und
- wenigstens ein mechanisches Einlegeteil zur mechanischen Fixierung zumindest eines elektronischen Bauteils auf der Trägerleiterplatte. Erfindungsgemäß ist eine einteilig ausgebildete Kapselung vorgesehen, welche alle auf der bestückten Flachseite angeordneten Komponenten form- und stoffschlüssig umgibt.

Die mechatronische Baugruppe ist insbesondere als Steuergerät für ein Kraftfahrzeug, beispielsweise als ein Getriebesteuergerät, geeignet.

Die Trägerleiterplatte ist hierbei als Schaltungsträger ausgebildet, wobei die elektronischen Bauteile in Form ungehäuster Halbleiterkomponenten (auch als "Bare Dies" bekannt) und/oder als gehäuste Halbleiterkomponenten direkt auf der Flachseite der Trägerleiterplatte angeordnet sind. Ungehäuste Halbleiterkomponenten werden mittels elektrischer Verbindungselemente, wie z. B. Bonddrähten, und leitfähigen Klebeverbindungen , mit der Trägerleiterplatte und somit mit weiteren darauf angeordneten elektronischen Bauteilen verbunden. Gehäuste Halbleiterkomponenten sind elektronische Bauteile, die mittels einer Umspritzung bzw. einem Gehäuse gegen äußere Einflüsse geschützt sind und über eine beliebige Verbindung mittels Löt- oder Steckprozessen mit der Trägerleiterplatte und somit anderen Komponenten verbunden sind. Es gibt drei Möglichkeiten die elektronischen Bauteile auf der Trägerleiterplatte zu platzieren. Einerseits direkt auf die Trägerleiterplatte in Form von gehäusten und/oder ungehäusten Komponenten. Andererseits ist es denkbar, die ungehäusten Komponenten auf einem Leiterplattenelement, z.B. eine HDI-Leiterplatte, zu bestücken und dieses auf die Trägerleiterplatte mittels einer Verklebung, z.B. Wärmeleitkleber, stoffschlüssig zu verbinden.

Das wenigstens eine mechanische Einlegeteil ist hierbei ein mechanisches Fixierelement, welches eine Position des elektronischen Bauteils auf der Trägerleiterplatte fixiert. Das mechanische Einlegeteil kann zusätzlich zur elektrischen Kontaktierung und/oder Versteifung des elektronischen Bauteils verwendet werden. Beispielsweise ist ein mechanisches Einlegeteil ein Sensordom.

Die Kapselung umgibt alle Komponenten auf der bestückten Flachseite der Trägerleiterplatte vollständig und einteilig, so dass sowohl die elektronischen Bauteile, das wenigstens eine mechanische Einlegeteil sowie alle weiteren Verbindungselemente zur elektrischen Kontaktierung der elektronischen Bauteile vor äußeren Einflüssen, wie z. B. Späne, Getriebeöl, geschützt sind. Aufgrund der einteiligen Ausbildung der Kapselung sind auch die Zwischenräume zwischen den elektronischen Bauteilen verschlossen, so dass offene Schnittstellen vermieden sind. Mittels der Kapselung ist damit für die mechatronische Baugruppe eine optimale Kombination von Elektronikschutz und einem Gehäusekonzept mit einem gegenüber dem Stand der Technik verringerten Bauraumbedarf ermöglicht. Des Weiteren ist aufgrund der Kapselung eine dichtende Funktion gegenüber der Verwendung mehrerer Gehäuse, die zueinander abgedichtet werden müssen, erheblich verbessert.

Vorzugsweise ist die Kapselung aus einem aushärtbaren Kapselungsmaterial gebildet, so dass der Form- und Stoffschluss zwischen der Kapselung und der Komponenten besonders einfach herstellbar ist.

In einer Ausgestaltung der Erfindung umfasst das aushärtbare Kapselungsmaterial ein Duroplast, welches elektrisch isolierende Eigenschaften aufweist, so dass ein Kurzschluss zwischen den elektronischen Bauteilen vermieden ist. Das Duroplast ist beispielsweise ein Polymer auf Epoxidbasis.

Gemäß einer bevorzugten Ausgestaltung der Erfindung ist das Kapselungsmaterial mit wenigstens einem anorganischen Füllstoff versehen. Als anorganische Füllstoffe eignen sich beispielsweise Siliziumdioxid oder Aluminiumoxid. Damit kann ein thermischer Ausdehnungskoeffizient der Kapselung derart an die Trägerleiterplatte, insbesondere an die Materialien, welche die Trägerleiterplatte umfasst, angepasst werden, dass ein Verzug der Kapselung vermieden oder zumindest verringert werden kann. Ebenso kann die thermische Dehnung der Kapselung über die thermischen Eigenschaften, insbesondere thermische Dehnung, Steifigkeit und Glasübergangstemperatur angepasst werden.

In einer weiteren Ausgestaltung der Erfindung weist die Kapselung mindestens eine Versteifungsrippe auf.

Die Versteifungsrippe ist beispielsweise in Form einer Bienenwabenstruktur oder in Form gekreuzter Rippen ausgeführt. Alternativ sind auch andere Geometrien und/oder mehrere Versteifungsrippen denkbar. Die Versteifungsrippe ermöglicht eine Versteifung der mechatronischen Baugruppe, wodurch die im Stand der Technik beschriebene Grundplatte, insbesondere Aluminiumgrundplatte, entfallen kann. Eine mechanische Stabilität der mechatronischen Baugruppe ist somit auch bei mechanisch hoher Beanspruchung während der Montage und/oder im Betrieb sichergestellt. Alternativ oder zusätzlich ist es möglich, eine andere versteifende Struktur, z. B. ein/eine mit Kunststoff umspritzte/s Metallgitter oder -platte, anzuordnen.

Eine weitere Ausgestaltung der Erfindung sieht vor, dass die Kapselung zusätzlich eine der bestückten Flachseite gegenüberliegende Flachseite der Trägerleiterplatte zumindest teilweise umgibt. Die Kapselung dient somit zusätzlich der Versteifung und dem Schutz einer unbestückten Rückseite, z. B. als Spanschutz. Alternativ können auf der Rückseite auch ein elektronisches Bauteil oder mehrere elektronische Bauteile, z. B ein Sensor, angeordnet sein, welche mittels der Kapselung vor äußeren Einflüssen geschützt sind.

Gemäß einer Ausgestaltung der Erfindung umfasst die mechatronische Baugruppe eine elektrische Schaltungsanordnung und mindestens einen Sensor.

Die elektronische Schaltungsanordnung ist beispielsweise modulartig ausgebildet und umfasst eine Mehrzahl elektrisch miteinander verbundener Bauteile, die zu einem Schaltkreis zusammengeführt sind. Als mindestens ein Sensor kann beispielsweise ein Hall-Sensor und/oder ein Drucksensor verwendet werden. Zusätzlich umfasst die mechatronische Baugruppe eine Anzahl elektrischer Verbindungselemente zur elektrischen Kontaktierung der elektronischen Komponenten mit weiteren elektronischen Komponenten, z. B. stromführenden Teilen eines Getriebes des Kraftfahrzeugs.

Gemäß einer weiteren Ausgestaltung der Erfindung ist zwischen der elektronischen Schaltungsanordnung und der Trägerleiterplatte ein Leiterplattenelement angeordnet, welches beispielweise eine HDI-Leiterplatte darstellt. Das Leiterplattenelement ist mit der Trägerleiterplatte mittels einer Verklebung, z. B. Wärmeleitkleber, stoffschlüssig verbindbar. Die elektronische Schaltungsanordnung umfasst dabei z. B. ungehäuste Komponenten, insbesondere ungehäuste Halbleiterkomponenten. Alternativ ist es möglich, die elektronische Schaltungsanordnung direkt auf der Trägerleiterplatte anzuordnen. Dies ist sowohl mit gehäusten als auch mit ungehäusten Komponenten möglich.

Es ist weiterhin ein Verfahren zur Herstellung einer mechatronischen Baugruppe vorgesehen, wobei zumindest eine Flachseite einer Trägerleiterplatte mit einer Mehrzahl elektronischer Bauteile bestückt wird, wobei zumindest ein elektronisches Bauteil mit wenigstens einem mechanischen Einlegeteil mechanisch auf der Flachseite der Trägerleiterplatte fixiert wird. Erfindungsgemäß werden die Mehrzahl elektronischer Bauteile und das wenigstens eine mechanische Einlegeteil mit einem aushärtbaren Kapselungsmaterial, z. B. mit einem Duroplast, insbesondere mit Epoxid versehen, welches sich beim Aushärten mit den elektronischen Bauteilen und dem wenigstens einen mechanischen Einlegeteil form- und stoffschlüssig verbindet und diese einteilig einkapselt.

Das Verfahren ermöglicht die Herstellung und Anbindung einer Kapselung an die Trägerleiterplatte, welche die Mehrzahl elektronischer Bauteile aufnimmt. Damit können gegenüber dem Stand der Technik ein Herstellungsaufwand und Materialkosten für die Kapselung optimiert werden. Zudem sind alle elektrischen Schnittstellen auf der Trägerleiterplatte mittels der Kapselung geschützt.

Gemäß einer Ausgestaltung der Erfindung wird das aushärtbare Kapselungsmaterial in ein Formwerkzeug eingefüllt, wobei die Trägerleiterplatte mit der bestückten Flachseite, auf welcher die elektronischen Bauteile sowie das mindestens eine mechanische Einlegeteil angeordnet ist, in das Formwerkzeug eingetaucht wird. Damit ist ein mediendichter, form- und stoffschlüssiger Verbund des ausgehärteten Kapselungsmaterials mit den elektronischen Bauteilen und des wenigstens einen mechanischen Einlegeteils möglich.

Gemäß einer alternativen Ausgestaltung der Erfindung wird das aushärtbare Kapselungsmaterial auf die bestückte Flachseite der Trägerleiterplatte gespritzt.

Hierbei ist ebenso ein mediendichter, form- und stoffschlüssiger Verbund des ausgehärteten Kapselungsmaterials mit den elektronischen Bauteilen und des wenigstens einen mechanischen Einlegeteils möglich.

Ausführungsbeispiele der Erfindung werden im Folgenden anhand von Zeichnungen näher erläutert.

Darin zeigen:
- Figur 1: eine schematische Schnittdarstellung einer mechatronischen Baugruppe gemäß dem Stand der Technik,
- Figur 2: eine schematische Schnittdarstellung einer alternativen mechatronischen Baugruppe gemäß dem Stand der Technik,
- Figur 3: eine schematische Schnittdarstellung eines erfindungsgemäßen Ausführungsbeispiels einer mechatronischen Baugruppe im fertig hergestellten Zustand,
- Figur 4: eine schematische Schnittdarstellung eines alternativen erfindungsgemäßen Ausführungsbeispiels einer mechatronischen Baugruppe im fertig hergestellten Zustand, und
- Figur 5: eine schematische Schnittdarstellung der mechatronischen Baugruppe gemäß Figur 3 während eines Herstellungsschrittes.

Einander entsprechende Teile sind in allen Figuren mit den gleichen Bezugszeichen versehen.

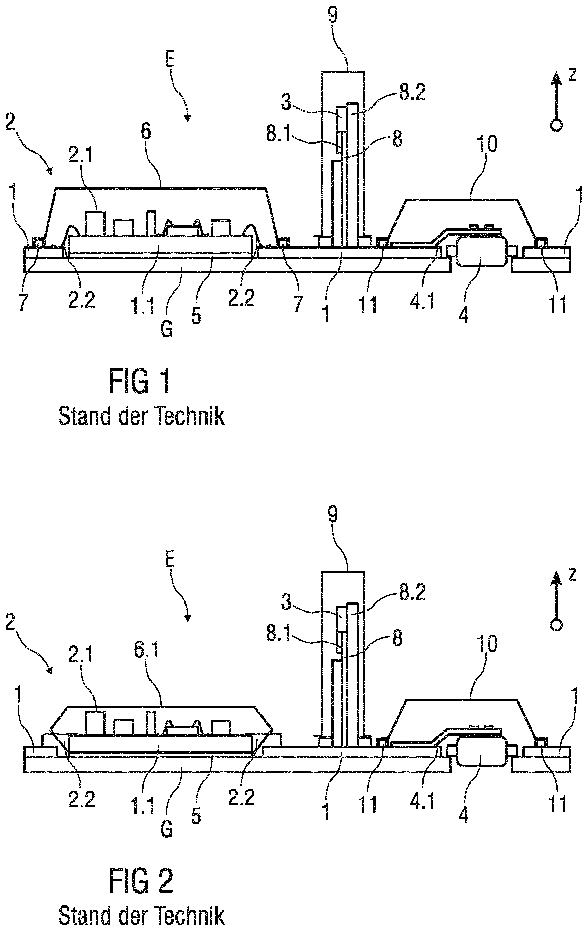

Figur 1 zeigt eine mechatronische Baugruppe E in einer Schnittdarstellung gemäß dem Stand der Technik.

Die mechatronische Baugruppe E ist beispielsweise als Steuergerät für Kraftfahrzeuge, insbesondere als Getriebesteuergerät vorgesehen.

Die mechatronische Baugruppe E umfasst eine Grundplatte G, eine Trägerleiterplatte 1, die im gezeigten Ausführungsbeispiel auf einer Flachseite einen ersten Sensor 3 mit einem ersten mechanischen Einlegeteil 8 und einen zweiten Sensor 4 mit einem zweiten mechanischen Einlegeteil 4.1 aufweist. Die mechatronische Baugruppe E umfasst weiterhin ein Leiterplattenelement 1.1 mit einer auf einer Flachseite aufgebrachten modulartigen elektrischen Schaltungsanordnung 2.

Die Grundplatte G dient der mechanischen Stabilisierung und der Entwärmung der auf der Trägerleiterplatte 1 und auf dem Leiterplattenelement 1.1 angeordneten, elektrischen Komponenten, hierbei der erste und zweite Sensor 3, 4 sowie die elektronische Schaltungsanordnung 2. Die Grundplatte G kann als metallische Grundplatte z.B. Aluminiumgrundplatte ausgeführt sein.

Die Trägerleiterplatte 1 ist als sogenannte Umstromungsleiterplatte ausgebildet und weist mindestens eine Lage mit elektrisch leitenden Kupferbahnen zur elektrischen Verbindung auf. In einem nicht gezeigten Ausführungsbeispiel kann die Trägerleiterplatte 1 auch beidseitig bestückt sein.

Die gezeigte elektrische Schaltungsanordnung 2 ist modulartig auf dem Leiterplattenelement 1.1 ausgebildet und umfasst eine elektronische Baugruppe 2.1, beispielsweise Transistoren, elektrische Widerstände, Speicherbausteine usw.

Im gezeigten Ausführungsbeispiel ist die elektrische Schaltungsanordnung 2 mittels zwei Bonddrähten 2.2 mit der Trägerleiterplatte 1 elektrisch leitend verbunden. Die Bonddrähte 2.2 sind beispielsweise als Aluminiumdickdrahtbond oder Aluminiumdünndrahtbond ausgeführt. Alternativ können die Bonddrähten 2.2 auch aus Gold gebildet sein. Weiterhin kann anstelle von zwei Bonddrähten 2.2 auch nur ein Bonddraht 2.2 oder mehrere Bonddrähte 2.2 angeordnet sein.

Die mechanische Anbindung der elektrischen Schaltungsanordnung 2 an die Grundplatte G ist mittels Stoffschluss realisiert, wobei die elektrische Schaltungsanordnung 2 über das Leiterplattenelement 1.1 mit der Grundplatte G verbunden ist. Das Leiterplattenelement 1.1 ist mit der Grundplatte G im gezeigten Ausführungsbeispiel mittels eines Klebemittels 5, z. B. ein Wärmeleitkleber, stoffschlüssig verbunden. Das Leiterplattenelement 1.1 ist beispielsweise als sogenannte HDI-Leiterplatte (High-Density-Interconnect-Leiterplatte) ausgebildet.

Die elektrische Schaltungsanordnung 2 ist von einem ersten Abdeckelement 6 umgeben, welches die elektrische Schaltungsanordnung 2 sowie die Bonddrähte 2.2 umschließend auf der Flachseite der Trägerleiterplatte 1 angeordnet ist. Das erste Abdeckelement 6 ist dabei kraft- und/oder form- und/oder stoffschlüssig mit der Flachseite der Trägerleiterplatte 1 verbunden. Im gezeigten Ausführungsbeispiel ist ein Verbindungsbereich zwischen der Flachseite der Trägerleiterplatte 1 und dem ersten Abdeckelement 6 mit einem ersten Dichtelement 7 versehen. Das erste Dichtelement 7 kann dabei als eine Festkörperdichtung oder alternativ als eine Spritzdichtung oder ein Klebstoff ausgebildet sein.

Der erste Sensor 3 ist auf der Flachseite der Trägerleiterplatte 1 beabstandet zur elektrischen Schaltungsanordnung 2 angeordnet und beispielsweise als Hall-Sensor, piezoelektrischer Sensor oder dgl. mehr ausgeführt. Das erste mechanische Einlegeteil 8 ist als Hybridspritzgussteil ausgebildet und umfasst einen metallischen Träger 8.1 zur elektrischen Kontaktierung und mechanischen Fixierung des ersten Sensors 3 und eine Kunststoffummantelung 8.2, welche einen Teil des ersten mechanischen Einlegeteils 8 elektrisch isoliert. Das erste mechanische Einlegeteil 8 ist hierbei stoffschlüssig und/oder kraftschlüssig und/oder formschlüssig mit der Flachseite der Trägerleiterplatte 1 verbunden.

Der erste Sensor 3 ist gemeinsam mit dem ersten mechanischen Einlegeteil 8 von einem zweiten Abdeckelement 9 umgeben, welches im vorliegenden Ausführungsbeispiel an der Kunststoffummantelung 8.2 angeordnet ist. Das zweite Abdeckelement 9 ist hierbei kraft- und/oder form- und/oder stoffschlüssig mit dem ersten mechanischen Einlegeteil 8 verbunden.

Der zweite Sensor 4 ist auf der Flachseite der Trägerleiterplatte 1 beabstandet zum ersten Sensor 3 angeordnet und beispielsweise als Drucksensor oder dgl. mehr ausgeführt. Im gezeigten Ausführungsbeispiel ist das zweite mechanische Einlegeteil 4.1 als eine Stromschiene ausgebildet, mittels welcher der zweite Sensor 4 mechanisch und elektrisch leitend mit der Trägerleiterplatte 1 verbunden ist. Die Stromschiene kann z.B. eine Folie oder ein umspritztes Stanzgitter sein.

Der zweite Sensor 4 ist gemeinsam mit dem zweiten mechanischen Einlegeteil 4.1 von einem dritten Abdeckelement 10 umgeben, welches kraft- und/oder form- und/oder stoffschlüssig mit der Flachseite der Trägerleiterplatte 1 verbunden ist. Analog zum ersten Abdeckelement 6 ist das dritte Abdeckelement 10 mit einem zweiten Dichtelement 11 versehen, welches im vorliegenden Ausführungsbeispiel am Verbindungsbereich zwischen der Flachseite der Trägerleiterplatte 1 und dem dritten Abdeckelement 10 angeordnet ist. Das zweite Dichtelement 11 kann analog zum ersten Dichtelement 7 als eine Festkörperdichtung oder alternativ als eine Spritzdichtung oder ein Klebstoff ausgebildet sein.

Die Abdeckelemente 6, 9, 10 dienen dem Schutz der Komponenten auf der Trägerleiterplatte 1 vor äußeren Einflüssen. Mit anderen Worten: Die elektrische Schaltungsanordnung 2, der erste Sensor 3 und der zweite Sensor 4 sowie die mechanischen Einlegeteile 4.1, 8 sind mittels der separaten Abdeckelemente 6, 9, 10 beispielsweise vor Getriebeöl geschützt. Zur Abdichtung der Abdeckelemente 6, 9, 10 sind das erste Dichtelement 7, das zweite Dichtelement 11 sowie die stoffschlüssige Verbindung zwischen der Kunststoffummantelung 8.2 und dem zweiten Abdeckelement 9 vorgesehen.

Figur 2 zeigt eine Schnittdarstellung einer mechanischen Baugruppe E gemäß dem Stand der Technik mit einem ähnlichen Aufbau wie es Figur 1 zeigt.

Der Unterschied ist hierbei, dass die elektrische Schaltungsanordnung 2 auf dem Leiterplattenelement 1.1 anstelle des ersten Abdeckelements 6 mittels einer Kunststoffumhüllung 6.1 geschützt wird. Das Leiterplattenelement 1.1 wird mittels eines Klebemittels 5, hierbei ebenfalls ein Wärmeleitkleber, mit der Grundplatte G stoffschlüssig verbunden. Die elektrische Kontaktierung zur Trägerleiterplatte 1 erfolgt gemäß der vorliegenden Darstellung über ein Stanzgitter oder eine flexible Folie. Alternativ kann die elektrische Kontaktierung auch über ein Herausführen des Leiterplattenelements 1.1 zur direkten Kontaktierung mittels z.B. Lot mit der Trägerleiterplatte 1 erfolgen. Der restliche Aufbau der mechatronischen Baugruppe E ist analog der Figur 1.

Zur Reduzierung von Bauteilen und einer mediendichten sowie temperaturbeständigen Abdichtung der Komponenten der mechatronischen Baugruppe E sieht die Erfindung eine einteilig ausgebildete Kapselung 12 vor, welche alle auf der Trägerleiterplatte 1 angeordneten Komponenten gemeinsam umschließt. Im Hinblick auf das gezeigte Ausführungsbeispiel heißt dies: Die elektrische Schaltungsanordnung 2, der erste Sensor 3 und der zweite Sensor 4 sowie deren mechanischen Einlegeteile 4.1, 8 werden von einer gemeinsamen Kapselung 12 vor äußeren Einflüssen geschützt.

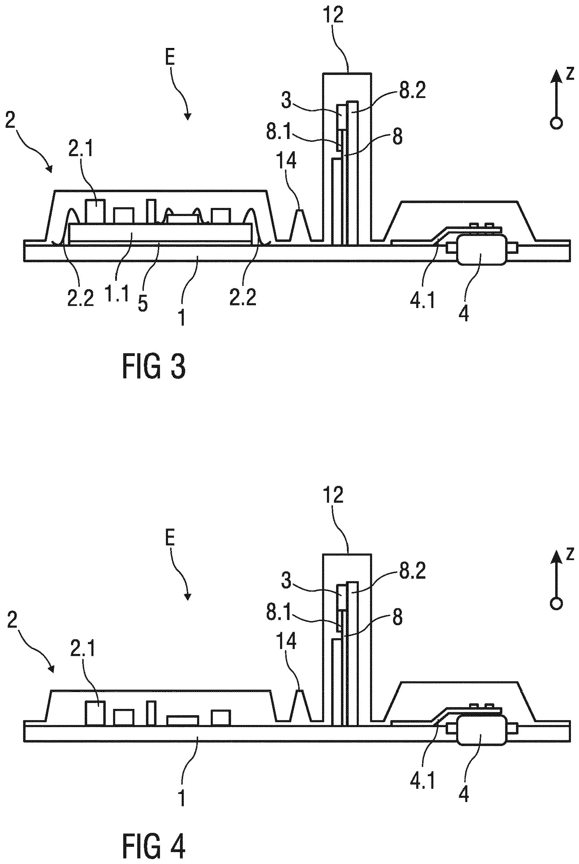

Figur 3 zeigt dazu ein erfindungsgemäßes Ausführungsbeispiel einer mechatronischen Baugruppe E mit einer Kapselung 12 in einer Schnittdarstellung, wobei die mechatronische Baugruppe E die elektrische Schaltungsanordnung 2, den ersten Sensor 3 und den zweiten Sensor 4 sowie deren mechanische Einlegeteile 4.1, 8 umfasst, wie zuvor beschrieben. Weiterhin umfasst die Kapselung 12 eine Versteifungsrippe 14. Die Versteifungsrippe 14 ist beispielsweise in Form einer Bienenwabenstruktur oder in Form gekreuzter Rippen ausgeführt. Alternativ sind auch mehrere Versteifungsrippen 14 anordenbar.

Die Abdeckelemente 6, 9, 10 sind hierbei nicht angeordnet. Vielmehr sind die dargestellten Komponenten mittels der einteiligen Kapselung 12, welche die Komponenten form- und stoffschlüssig umgibt, vor äußeren Einflüssen geschützt. Dabei sind auch die Zwischenräume zwischen der elektrischen Schaltungsanordnung 2 und den Sensoren 3, 4 mit deren mechanischen Einlegeteilen 4.1, 8 mittels der Kapselung 12 verschlossen, so dass aufgrund fehlender offener Schnittstellen eine Sicherheit der mechatronischen Baugruppe E, insbesondere in deren Betrieb, gegenüber dem Stand der Technik verbessert ist. Zudem kann mittels der Versteifungsrippe 14 die Grundplatte G entfallen und die Entwärmung der elektrischen Komponenten über Durchkontaktierungen (auch als Thermovias bezeichnet) erfolgen.

Figur 4 zeigt ein alternatives erfindungsgemäßes Ausführungsbeispiel einer mechatronischen Baugruppe E.

Die mechatronische Baugruppe E umfasst analog zum in Figur 3 gezeigten Ausführungsbeispiel die elektrische Schaltungsanordnung 2 und die Sensoren 3, 4 mit deren mechanischen Einlegeteilen 4.1, 8.

Hierbei ist die elektrische Schaltungsanordnung 2 nicht über ein Leiterplattenelement 1.1 mit der Trägerleiterplatte 1 verbunden, wie es in Figur 3 gezeigt wird, sondern unmittelbar auf der Flachseite der Trägerleiterplatte 1 angeordnet und mit dieser verbunden. Die elektronischen Komponenten der elektrischen Schaltungsanordnung 2 sind mit der Trägerleiterplatte 1 verlötet oder verklebt, so dass keine Bonddrähte 2.2 zur elektrischen Verschaltung notwendig sind. Auch hierbei ist es möglich, entweder gehäuste oder ungehäuste Komponenten für die elektronische Schaltungsanordnung 2 zu verwenden.

Des Weiteren sind die elektrische Schaltungsanordnung 2 und die Sensoren 3, 4 sowie deren mechanische Einlegeteile 4.1, 8 von der Kapselung 12 form- und stoffschlüssig umgeben, wie es in Figur 3 bereits beschrieben ist.

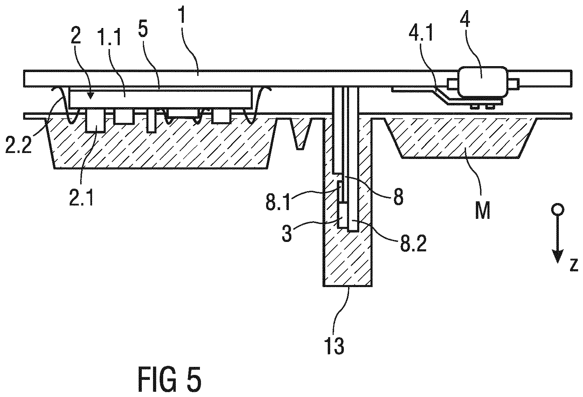

Die Kapselung 12 wird im Folgenden anhand von Figur 5 näher beschrieben.

Figur 5 zeigt dabei die mechatronische Baugruppe E gemäß Figur 3 in einer Schnittdarstellung während der Herstellung der Kapselung 12 mit einem Formwerkzeug 13.

Das Formwerkzeug 13 weist eine vereinfachte Negativform der bestückten Flachseite der Trägerleiterplatte 1 und zusätzlich eine Kavität zur Ausformung der Versteifungsrippe 14 auf.

Im Formwerkzeug 13 befindet sich ein Kapselungsmaterial M, welches in Form eines Granulats, oder in flüssiger Form in das Formwerkzeug 13 eingefüllt und anschließend erwärmt bzw. erhitzt wird. Als Kapselungsmaterial M ist insbesondere ein Duroplast vorgesehen. Der Duroplast ist beispielsweise ein Polymer auf Epoxidbasis, welche mit anorganischen Füllstoffen versetzt ist. Als anorganische Füllstoffe eignen sich beispielsweise Siliziumdioxid oder Aluminiumoxid. Mittels der anorganischen Füllstoffe kann in Abhängigkeit einer Füllstoffmenge ein thermischer Ausdehnungskoeffizient der Kapselung 12 an die Trägerleiterplatte 1 und insbesondere an die Materialien der Trägerleiterplatte 1 angepasst werden, so dass ein Verzug der Kapselung 12 vermieden oder zumindest verringert werden kann.

Zur Herstellung und Anbringung der Kapselung 12 wird die Trägerleiterplatte 1 mit der bestückten Flachseite in das Formwerkzeug 13 eingetaucht, so dass die elektrische Schaltungsanordnung 2, der erste Sensor 3,der zweite Sensor 4 sowie deren mechanische Einlegeteile 4.1, 8 vollständig vom flüssigen Kapselungsmaterial M im Formwerkzeug 13 umgeben sind. Vorzugsweise wird das Formwerkzeug 13 vakuumdicht verschlossen.

Nach einer chemischen Aushärtung und Abkühlung des flüssigen Kapselungsmaterials M ist die Kapselung 12 form- und stoffschlüssig mit der elektrischen Schaltungsanordnung 2, dem ersten Sensor 3, zweiten Sensor 4, deren mechanischen Einlegeteilen 4.1, 8 sowie der Flachseite der Trägerleiterplatte 1 verbunden.

Somit ist es möglich, mittels einer einzigen Kapselung 12 sowohl die modulartige, elektrische Schaltungsanordnung 2 als auch die auf der Trägerleiterplatte 1 zusätzlich positionierten Sensoren 3, 4 und deren mechanische Einlegeteile 4.1, 8 zu umhüllen.

Dadurch werden gegenüber dem Stand der Technik Montageschritte und Abdichtungsmaßnahmen reduziert.

Das beschriebene Verfahren zur Herstellung und Anbringung der Kapselung 12 ist auch als Formpressen bekannt. Alternativ ist auch Spritzpressen möglich, wobei die bestückte Flachseite der Trägerleiterplatte 1 in der Kavität des Formwerkzeugs 13 angeordnet wird und anschließend das flüssige, erhitzte Kapselungsmaterial M über ein Gießkanal- oder Kolbensystem über einen Kanal in das Formwerkzeug 13 eingebracht wird. Hierbei ist ein vakuumdichter Verschluss des Formwerkzeugs 13 nicht notwendig. Des Weiteren ist auch Spritzguss möglich, wobei das flüssige Kapselungsmaterial M über einen Anguss um die Komponenten auf der Trägerleiterplatte 1 gespritzt wird.

Denkbar ist auch, die Kapselung 12 mittels eines sogenannten Sheet Molding Compounds auf die Trägerleiterplatte 1 anzubringen. Hierbei wird ein Material gemäß der oben beschriebenen Zusammensetzung in einem unausgehärteten Zustand als Folie auf der bestückten Flachseite der Trägerleiterplatte 1 angeordnet. Durch einen thermischen Prozess erfolgt zunächst eine Aufschmelzung des Sheet Molding Compounds, wobei sich dieses formschlüssig um die zu umhüllenden Komponenten auf der Trägerleiterplatte 1 legt und anschließend aushärtet. Dadurch ist ein mediendichter, adhäsiver Verbund zwischen den Komponenten auf der Trägerleiterplatte 1, der Trägerleiterplatte 1 selbst und der Kapselung 12 ermöglicht. Der thermische Prozess kann mittels eines formgebenden Werkzeugs, in einem Ofen bei Normaldruck oder auch im Vakuum initiiert werden.

Bei der in Figur 3 gezeigten mechatronischen Baugruppe E mit der fertig hergestellten Kapselung 12 ist zwischen der Kapselung 12, der elektrischen Schaltungsanordnung 2, den Sensoren 3, 4 mit deren mechanischen Einlegeteilen 4.1, 8 sowie der Flachseite der Trägerleiterplatte 1 ein mediendichter und temperaturbeständiger Verbund realisiert.

Die Erfindung ermöglicht somit eine optimale Kombination von Elektronikschutz und einem Gehäusekonzept, welches ein extrem flaches Gehäuse als Kapselung 12 ermöglicht. Die Anzahl von Bauteilen und Prozessschritte zur Abdichtung der Komponenten auf der Trägerleiterplatte 1 ist dabei gegenüber dem Stand der Technik reduziert. Diese Kombination ist möglich, da die dargestellte Lösung im Vergleich zu anderen Steuergeräten, bei denen z.B. Substrate auf Basis von Keramik verwendet werden, eine einheitliche organische Substrattechnologie verwendet, die sowohl Logik- als auch Leistungskomponenten umfassen kann. Dadurch können Unterschiede bei thermischer Ausdehnung verringert werden.

Ein weiterer Vorteil der Erfindung ergibt sich daraus, dass mittels der gemeinsamen Kapselung 12 ein Verzug (Bimetall-Effekt) und Delaminationen (Thermomechanische Spannungen durch unterschiedliche thermische Dehnung) vermeidbar oder zumindest verringerbar sind.

Ferner ermöglicht die Erfindung aufgrund einer Viskosität des Kapselungsmaterials M die Anordnung mindestens eines Versteifungsmusters auf der Trägerleiterplatte 1, welches im vorliegenden Ausführungsbeispiel mittels der Versteifungsrippe 14 realisiert ist.

Dadurch ist es möglich, die mechatronische Baugruppe E ohne eine metallische Grundplatte G gemäß Figur 1 oder 2 zur Versteifung auszuführen. Die mit der Kapselung 12 versehene mechatronische Baugruppe E kann direkt auf ein Getriebegehäuse oder einer Hydraulikplatte montiert werden, z. B. mittels Schrauben, Nieten, Kleben, Laminieren und dergleichen mehr. Eine mechanische Stabilität der mechatronischen Baugruppe E ist somit auch bei mechanisch hoher Beanspruchung während der Montage und/oder im Betrieb sichergestellt.

Eine Kühlung der mechatronischen Baugruppe E durch Abfuhr von Verlustwärme kann beispielsweise mittels der zuvor erwähnten Durchkontaktierungen (Thermovias) erfolgen, die in die Trägerleiterplatte 1 eingebracht sind. Zusätzlich kann die Kühlung mittels eines mit thermisch hochleitfähigen Partikeln gefüllten Duroplasten erfolgen, wodurch eine beidseitige, elektrische Anbindung der mechatronischen Baugruppe E an weitere Komponenten im Kraftfahrzeug denkbar ist.

Des Weiteren ist es möglich, anstelle eines einheitlichen Kapselungsmaterials M verschiedene Kapselungsmaterialien M zu verwenden, welche sich bei thermischer Aushärtung verbinden. Die Kapselungsmaterialien M können unterschiedliche Eigenschaften aufweisen, z. B. verschiedene thermische Ausdehnungskoeffizienten, Wärmeleitkoeffizienten, Kosten usw. Damit ist eine kostenoptimierte Materialauswahl für die Kapselung 12 möglich.

Die Erfindung ermöglicht weiterhin eine Verringerung von Bauteilen und Kosten, da mittels der Kapselung 12 stromführende Teile vor chemischen Reaktionen mit Luft oder Umgebungsatmosphäre geschützt sind. Somit können anstelle von kostenintensiven Materialien wie Gold oder Aluminium für Bonddrähte 2.2, Metallisierung und weitere stromführender Teile auch unbeschichtetes Kupfer verwendet werden.

Mittels der Kapselung 12 werden somit auch Zwischenräume der mechatronischen Baugruppe E umhüllt, so dass diese gegenüber äußeren Einflüssen, z. B. Späne zwischen elektronischen Bauteilen, aus denen Kurzschlüsse resultieren können, sowie chemisch angreifende Medien, z. B. Getriebeöl, geschützt sind. Somit sind gegenüber dem Stand der Technik zusätzlich zu den elektronischen Komponenten auch Fixierelemente, Verbindungselemente und Freiräume auf der Trägerleiterplatte 1 geschützt.

Aufgrund der zuvor beschriebenen Viskosität des Kapselungsmaterials M ist es zusätzlich möglich, z. B. eine unbestückte Flachseite der Trägerleiterplatte 1 mit einer Kapselung 12 in Form einer Kunststoffschicht zu versehen, wodurch eine verbesserte Anhaftung der Kapselung 12 auf der bestückten Flachseite sowie eine zusätzliche Versteifung der mechatronischen Baugruppe E resultiert. Die beidseitige Umhüllung der mechatronischen Baugruppe E kann durch in die Trägerleiterplatte 1 eingebrachte Aussparungen oder durch Aussparungen im Bereich zwischen dem Leiterplattenelement 1.1 und der Trägerleiterplatte 1 erfolgen.

Ferner kann die beidseitige Umhüllung der mechatronischen Baugruppe E auch als Abdeckung möglicher Lötschnittstellen dienen, wodurch z. B. das erste mechanische Einlegeteil 8 des ersten Sensors 3 vor äußeren Einflüssen, wie beispielsweise chemisch angreifenden Medien, geschützt wird. Da die Kapselung 12 auf verschiedenen Oberflächen unterschiedlich stark haftet, können zusätzlich Beschichtungen von Leiterplattenoberflächen oder Aktivierungsmaßnahmen erfolgen, mittels welcher ein Risiko einer Ablösung der Kapselung 12 von der Trägerleiterplatte 1 verringert wird.

Die Bestückung der Trägerleiterplatte 1 kann alternativ zu den gezeigten Ausführungsbeispielen auch auf der gegenüberliegenden Flachseite erfolgen, welche in Betrachtungsrichtung eine Rückseite oder Unterseite der Trägerleiterplatte 1 bildet. Als Kapselungsmaterial M wird dabei ein mit thermisch hochleitfähigen Partikeln gefülltes Duroplast verwendet. Dadurch kann die Kühlung der mechatronischen Baugruppe E über die Kapselung 12 direkt mit einer Temperiereinheit, z. B. eine Hydraulikplatte, erfolgen.

Ferner sind neben Versteifungsstrukturen auch Unterbrechungen in Form von Materialaussparungen in der Kapselung 12 denkbar, in denen Bereiche auf der Trägerleiterplatte 1 freigestellt sind. Die Unterbrechungen dienen beispielsweise Montagezwecken oder der Aufnahme elektrischer Anschlüsse von Steckverbindern.

### Bezugszeichenliste

- 1: Trägerleiterplatte
- 1.1: Leiterplattenelement
- 2: elektrische Schaltungsanordnung
- 2.1: elektronische Baugruppe
- 2.2: Bonddraht
- 3: erster Sensor
- 4: zweiter Sensor
- 4.1: zweites mechanisches Einlegeteil
- 5: Klebemittel
- 6: erstes Abdeckelement
- 6.1: Kunststoffumhüllung
- 7: erstes Dichtelement
- 8: erstes mechanisches Einlegeteil
- 8.1: metallischer Träger
- 8.2: Kunststoffummantelung
- 9: zweites Abdeckelement
- 10: drittes Abdeckelement
- 11: zweites Dichtelement
- 12: Kapselung
- 13: Formwerkzeug
- 14: Versteifungsrippe

- E: mechatronische Baugruppe
- G: Grundplatte
- M: Kapselungsmaterial

- Z: Hochachse

## Patentansprüche

1. Mechatronische Baugruppe (E) eines Getriebesteuergeräts, umfassend
- eine Trägerleiterplatte (1) mit wenigstens einer bestückten Flachseite, auf der folgende Komponenten angeordnet sind:
- eine Mehrzahl elektronischer Bauteile, und
- zumindest ein mechanisches Einlegeteil (4.1, 8), welches als mechanisches Fixierelement zur mechanischen Fixierung zumindest eines elektronischen Bauteils auf der Trägerleiterplatte (1) ausgebildet ist, wobei eine einteilig ausgebildete Kapselung (12) alle auf der bestückten Flachseite der Trägerleiterplatte (1) angeordneten Komponenten form- und stoffschlüssig umgibt.

2. Mechatronische Baugruppe (E) nach Anspruch 1,
**dadurch gekennzeichnet, dass** die Kapselung (12) aus einem aushärtbaren Kapselungsmaterial (M) gebildet ist.

3. Mechatronische Baugruppe (E) nach Anspruch 2,
**dadurch gekennzeichnet, dass** das aushärtbare Kapselungsmaterial (M) einen Duroplast umfasst.

4. Mechatronische Baugruppe (E) nach Anspruch 2 oder 3,
**dadurch gekennzeichnet, dass** das aushärtbare Kapselungsmaterial (M) mit wenigstens einem anorganischen Füllstoff versehen ist.

5. Mechatronische Baugruppe (E) nach einem der vorhergehenden Ansprüche,
**dadurch gekennzeichnet, dass** die Kapselung (12) mindestens eine Versteifungsrippe (14) aufweist.

6. Mechatronische Baugruppe (E) nach einem der vorhergehenden Ansprüche,
**dadurch gekennzeichnet, dass** die Kapselung (12) zusätzlich eine der bestückten Flachseite gegenüberliegende Flachseite der Trägerleiterplatte (1) zumindest teilweise umgibt.

7. Mechatronische Baugruppe (E) nach einem der vorhergehenden Ansprüche,
**gekennzeichnet durch**
- eine elektrische Schaltungsanordnung (2) mit einer elektronischen Baugruppe (2.1) und
- mindestens einen Sensor (3, 4).

8. Mechatronische Baugruppe (E) nach Anspruch 7,
**dadurch gekennzeichnet, dass** zwischen der elektrischen Schaltungsanordnung (2) ein Leiterplattenelement (1.1.) angeordnet ist.

9. Verfahren zur Herstellung einer mechatronischen Baugruppe (E) eines Getriebesteuergeräts, wobei zumindest eine Flachseite einer Trägerleiterplatte (1) mit einer Mehrzahl elektronischer Bauteile bestückt wird, wobei zumindest eines der elektronischen Bauteile mit wenigstens einem mechanischen Einlegeteil (4.1, 8) mechanisch auf der Flachseite der Trägerleiterplatte (1) fixiert wird, **dadurch gekennzeichnet, dass** die Mehrzahl elektronischer Bauteile einschließlich des wenigstens einen mechanischen Einlegeteils (4.1, 8) mit einem aushärtbaren Kapselungsmaterial (M) versehen werden, welches sich beim Aushärten mit den elektronischen Bauteilen und dem wenigstens einen mechanischen Einlegeteil (4.1, 8) form- und stoffschlüssig verbindet und diese einteilig kapselt.

10. Verfahren nach Anspruch 9,
**dadurch gekennzeichnet, dass** das aushärtbare Kapselungsmaterial (M) in ein Formwerkzeug (13) eingefüllt wird, wobei die Trägerleiterplatte (1) mit der bestückten Flachseite in das Formwerkzeug (13) eingetaucht wird.

11. Verfahren nach Anspruch 9,
**dadurch gekennzeichnet, dass** das aushärtbare Kapselungsmaterial (M) auf die bestückte Flachseite der Trägerleiterplatte (1) gespritzt wird.

## Claims

1. Mechatronic assembly (E) of a transmission control device, comprising:
- a supporting circuit board (1) with at least one populated flat side, on which the following components are arranged:
- a plurality of electronic components, and
- at least one mechanical insert part (4.1, 8) which is designed as a mechanical fixing element for the mechanical fixing of at least one electronic component on the supporting circuit board (1), wherein an encapsulation (12) of one-piece design, in a form-fitting and cohesive manner, surrounds all of the components arranged on the populated flat side of the supporting circuit board (1).

2. Mechatronic assembly (E) according to Claim 1, **characterized in that** the encapsulation (12) is formed of a curable encapsulation material (M).

3. Mechatronic assembly (E) according to Claim 2, **characterized in that** the curable encapsulation material (M) comprises a thermosetting plastic.

4. Mechatronic assembly (E) according to Claim 2 or 3, **characterized in that** the curable encapsulation material (M) incorporates at least one inorganic filler material.

5. Mechatronic assembly (E) according to one of the preceding claims,
**characterized in that** the encapsulation (12) has at least one reinforcing rib (14).

6. Mechatronic assembly (E) according to one of the preceding claims,
**characterized in that** the encapsulation (12) additionally at least partially encloses a flat side of the supporting circuit board (1) arranged opposite the populated flat side thereof.

7. Mechatronic assembly (E) according to one of the preceding claims,
**characterized by**:
- an electric circuit arrangement (2) with an electronic assembly (2.1), and
- at least one sensor (3, 4).

8. Mechatronic assembly (E) according to Claim 7, **characterized in that** a printed circuit board element (1.1) is arranged between the electric circuit arrangement (2).

9. Method for the production of a mechatronic assembly (E) of a transmission control device, wherein at least one flat side of a supporting circuit board (1) is populated with a plurality of electronic components, and wherein at least one electronic component is mechanically fixed to the flat side of the supporting circuit board (1) by at least one mechanical insert part (4.1, 8),
**characterized in that** a curable encapsulation material (M) is applied to the plurality of electronic components including the at least one mechanical insert part (4.1, 8) which material, upon curing, bonds with the electronic components and the at least one mechanical insert part (4.1, 8) in a form-fitting and cohesive manner, and encapsulates the latter in a one-piece arrangement.

10. Method according to Claim 9,
**characterized in that** the curable encapsulation material (M) is packed in a mold (13), wherein the supporting circuit board (1), with its populated flat side, is immersed in the mold (13).

11. Method according to Claim 9,
**characterized in that** the curable encapsulation material (M) is sprayed onto the populated flat side of the supporting circuit board (1).

## Revendications

1. Sous-ensemble mécatronique (E) d'un contrôleur de boîte de vitesses, comprenant
- un circuit imprimé porteur (1) comprenant au moins un côté plat garni sur lequel sont disposés les composants suivants :
- une pluralité de composants électroniques et
- au moins une pièce d'insertion mécanique (4.1, 8), laquelle est réalisée sous la forme d'un élément de calage mécanique servant à caler mécaniquement au moins un composant électronique sur le circuit imprimé porteur (1), un encapsulage (12) réalisé d'un seul tenant entourant par complémentarité de formes et par fusion de matières la totalité des composants disposés sur le côté plat garni du circuit imprimé porteur (1).

2. Sous-ensemble mécatronique (E) selon la revendication 1, **caractérisé en ce que** l'encapsulage (12) est constitué d'un matériau d'encapsulage (M) durcissable.

3. Sous-ensemble mécatronique (E) selon la revendication 2, **caractérisé en ce que** le matériau d'encapsulage (M) durcissable comprend une résine thermodurcissable.

4. Sous-ensemble mécatronique (E) selon la revendication 2 ou 3, **caractérisé en ce que** le matériau d'encapsulage (M) durcissable est pourvu d'au moins une matière de charge anorganique.

5. Sous-ensemble mécatronique (E) selon l'une des revendications précédentes, **caractérisé en ce que** l'encapsulage (12) possède au moins une membrure raidisseuse (14).

6. Sous-ensemble mécatronique (E) selon l'une des revendications précédentes, **caractérisé en ce que** l'encapsulage (12) entoure en plus au moins partiellement un côté plat du circuit imprimé porteur (1) à l'opposé du côté plat garni.

7. Sous-ensemble mécatronique (E) selon l'une des revendications précédentes, **caractérisé par**
- un arrangement de circuit électrique (2) comprenant un sous-ensemble électronique (2.1) et
- au moins un capteur (3, 4).

8. Sous-ensemble mécatronique (E) selon la revendication 7, **caractérisé en ce qu'**un élément de circuit imprimé (1.1) est disposé entre l'arrangement de circuit électrique (2).

9. Procédé de fabrication d'un sous-ensemble mécatronique (E) d'un contrôleur de boîte de vitesses, au moins un côté plat d'un circuit imprimé porteur (1) étant garni avec une pluralité de composants électroniques, au moins l'un des composants électroniques étant calé mécaniquement sur le côté plat du circuit imprimé porteur (1) avec au moins une pièce d'insertion mécanique (4.1, 8), **caractérisé en ce que** la pluralité de composants électroniques, y compris de l'au moins une pièce d'insertion mécanique (4.1, 8), est pourvue d'un matériau d'encapsulage (M) durcissable qui, lors du durcissement, se lie par complémentarité de formes et par fusion de matières aux composants électroniques et à l'au moins une pièce d'insertion mécanique (4.1, 8) et les encapsule d'un seul tenant.

10. Procédé selon la revendication 9, **caractérisé en ce que** le matériau d'encapsulage (M) durcissable est déversé dans un outil de formage (13), le circuit imprimé porteur (1) étant immergé dans l'outil de formage (13) avec le côté plat garni.

11. Procédé selon la revendication 9, **caractérisé en ce que** le matériau d'encapsulage (M) durcissable est pulvérisé sur le côté plat garni du circuit imprimé porteur (1).
